# FASCICULE DE BREVET EUROPEEN

(11) **EP 1 166 273 B1**
(45) Date de publication et mention de la délivrance du brevet: **18.12.2002**
(21) Numéro de dépôt: 00918932.5
(22) Date de dépôt: 10.04.2000
(51) Int. Cl.: G11C 7/00, B42D 15/02, G11C 7/24, G11C 7/16

(54) **DISPOSITIF ENREGISTREUR ET DIFFUSEUR DE SONS A USAGE UNIQUE**
TONAUFZEICHNUNG- UND WIEDERGABEVORRICHTUNG ZUM EINMALIGEN GEBRAUCH
DISPOSABLE SOUND RECORDING AND REPRODUCTION DEVICE

(30) Priorité: 13.04.1999 FR 9904590
(43) Date de publication de la demande: 02.01.2002
(73) Titulaire: Great Wealth Co. Ltd., Hong Kong (CN)
(72) Inventeur: DUBOIS, Jean-Pierre, F-75015 Paris (FR); LARZUL, Jean-Pierre, F-75001 Paris (FR)
(74) Mandataire: Wagret, Frédéric
(86) Numéro de dépôt international: FR0000910
(87) Numéro de publication internationale: WO00062300

(56) Documents cités:
- EP-A- 0 277 276
- GB-A- 2 268 119
- US-A- 5 836 616

## Description

La présente invention concerne des dispositifs portatifs aptes à enregistrer et diffuser un message et pourvus en outre de moyens de désactivation de la fonction enregistrement.

Ces moyens de désactivation permettent de ne pas effacer accidentellement le message une fois que l'utilisateur a réalisé son enregistrement, ou d'éviter qu'une tierce personne n'efface le message.

On connaît, par la demande de brevet français n° 2 697 938, un tel dispositif portatif conformé en carte postale afin de délivrer au destinataire un message sonore préalablement enregistré.

Cependant, ce dispositif connu n'est pas prévu pour être fixé sur un objet quelconque, à moins de fixer la carte postale sur l'objet avant ou après l'enregistrement. 11 faut donc prévoir de fixer le dispositif à l'objet, et ce de manière relativement fiable, en particulier si l'objet est ensuite pris en charge par les services postaux. Cette fixation du dispositif entraîne des manipulations supplémentaires en plus de l'enregistrement qui requiert déjà une série de manipulations, notamment pour neutraliser la fonction d'enregistrement.
Le brevet américain US 5 836 616 décrit une carte de visite électronique susceptible de délivrer un message audio, mais qui ne comporte pas de moyens de fixation sur un support puisque cela va à l'encontre de l'utilisation normale d'une carte de visite qui est destinée à être distribuée. Le dispositif divulgué par le document EP 0 277 276 ne comporte pas plus de moyens de fixation.

Le document GB 2 268 119 divulgue quant à lui une carte dotée de moyens d'enregistrement et de diffusion de sons ainsi que de moyens de désactivation de la fonction enregistrement.
Cependant, la désactivation de la fonction enregistrement n'est ni totale ni efficace puisque les moyens de fixation du dispositif de ce document ne permettent pas forcément cette désactivation.
En effet, si le dispositif est fixé sur une lettre ou un support souple, les contacts d'enregistrement sont toujours accessibles et quelqu'un ou quelque chose peut venir appuyer contre ces contacts et déclencher un enregistrement involontaire.

Dans ce contexte, la présente invention a pour but de pallier ces inconvénients en proposant un dispositif portatif apte à enregistrer et à diffuser un message sonore qui soit simple et rapide à fixer sur n'importe quel support, tout en s'assurant que le message ne sera pas effacé.

A cette fin selon l'invention, le dispositif enregistreur et diffuseur de sons comporte des moyens d'enregistrement associés à des moyens de restitution desdits sons, des moyens de fixation dudit dispositif sur un support, lesdits moyens de fixation comprenant un moyen adhésif associé à un organe amovible de protection, ainsi que des moyens de désactivation irréversible de la fonction enregistrement, est caractérisé en ce que les moyens de désactivation comprennent un élément amovible dont l'enlèvement provoque une rupture de contact, et solidaire de l'organe amovible de protection des moyens de fixation.

Avantageusement, le moyen adhésif est une bande adhésive double face et l'organe amovible de protection est une pellicule détachable.
De préférence, les moyens d'enregistrement et les moyens de restitution sont fixés sur une plaque de circuit imprimé.

Selon un mode préféré de réalisation, les moyens d'enregistrement, et les moyens de restitution sont fixés sur une première face de la plaque de circuit imprimé et les moyens de fixation sont fixés sur la seconde face.
De préférence, l'élément amovible est relié à la pellicule de protection par une languette.
Par ailleurs, selon un autre aspect de l'invention, les moyens d'enregistrement comprennent un microphone actionné par des moyens de commande tel qu'un bouton, et en ce qu'ils comprennent en outre une mémoire de type effaçable ré-enregistrable.
En outre, les moyens de restitution comprennent avantageusement un haut-parleur actionné par des moyens de commande tel qu'un bouton.

L'invention sera mieux comprise à la lumière de la description qui suit, se rapportant à un exemple de réalisation illustratif mais en aucun cas limitatif, en référence aux dessins annexés dans lesquels :
- La figure 1 représente une vue de trois-quarts en perspective du dispositif selon l'invention ;
- La figure 2 représente une coupe transversale du dispositif de la figure 1 ;
- Les figures 3a à 3f représentent, vu en coupe transversale, la séquence de montage du dispositif selon l'invention.

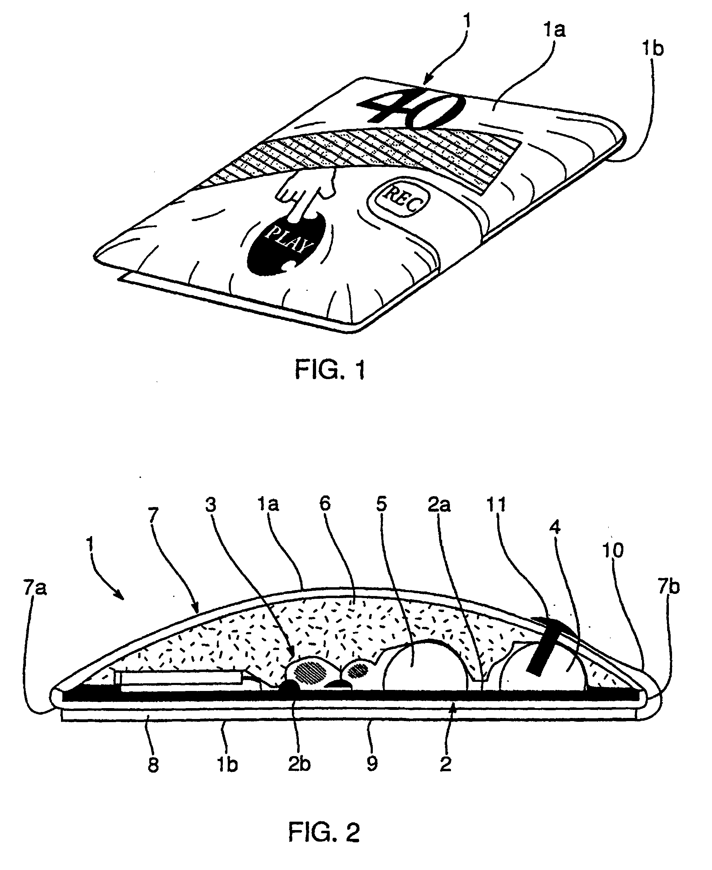

En référence à la figure 1, on a représenté en perspective, vu de trois-quarts, le dispositif enregistreur et diffuseur de sons 1 conforme à l'invention.

Celui-ci présente une forme sensiblement quadrangulaire, et de préférence sensiblement plane et carrée.

La face supérieure 1a (appelée également face avant) est légèrement bombée tandis que la face inférieure 1b (appelée également face arrière) présente une surface relativement plane.

Les dimensions du dispositif 1 peuvent varier selon les modes de réalisation mais de façon avantageuse la longueur d'un côté est de l'ordre quelques centimètres, de préférence entre 5 et 10 centimètres, pour une épaisseur d'environ 1 à 2 centimètres.

La figure 2 est une coupe transversale du dispositif 1 montrant l'implantation des différents composants.

Une plaque de circuit imprimé 2, donnant sa forme sensiblement carrée au dispositif 1, comporte une face inférieure 2b, parallèle à la face inférieure 1b du dispositif 1 et sensiblement au même niveau.

Sur la face supérieure 2a de cette plaque 2 sont fixés les différents composants 3 des moyens d'enregistrement et de restitution de sons, connus en eux-mêmes et représentés partiellement.

Les moyens d'enregistrement comportent par exemple un microphone connu en soi associé à un moyen de commande constitué avantageusement par un bouton 4 ainsi qu'une mémoire effaçable et ré-enregistrable.

Les moyens de restitution des sons comportent par exemple un haut-parleur, également connu en soi, associé à un moyen de commande tel qu'un bouton 5.

Ces moyens d'enregistrement et de restitution de sons peuvent revêtir tout types de forme et comporter tout types de composants 3 connus et nécessaires au fonctionnement du dispositif 1.

Afin de protéger les différents composants 3 fixés sur la face supérieure 2a de la plaque 2, un élément de protection souple 6 est prévu. Cet élément souple 6 est réalisé par exemple en mousse ou en fibre afin de parfaitement épouser les formes des composants 3 en occupant un espace limité.

L'élément de protection souple 6 se trouve compris entre, d'une part les composants 3 fixés sur la face supérieure 2a de la plaque 2, d'autre part une membrane de protection 7 chapeautant le tout et venant se rabattre sur la face inférieure 2b de la plaque 2.

La membrane 7, constituée d'un film de matière plastique par exemple, ou de papier plastifié, représente la face supérieure 1a du dispositif 1 et lui donne sa forme bombée.

Les flancs d'extrémités 7a et 7b de la membrane sont rabattus et fixés (par collage ou tout autre moyen connu) sur la face inférieure 2b de la plaque 2. Par dessus ces rabats, venant recouvrir totalement la surface de la face inférieure 2b de la plaque 2, est fixé un moyen adhésif 8.

Ce moyen adhésif est de préférence constitué d'une bande de papier adhésif du type double face dont l'une des faces est collée sur la face inférieure 2b de la plaque 2 et dont l'autre face est recouverte d'une pellicule de protection 9 matérialisant la face inférieure 1b du dispositif 1.

Les dimensions de ce moyen adhésif 8 sont rigoureusement identiques à celles de la plaque 2 afin de parfaitement recouvrir la face inférieure 2b de celle-ci sans pour autant déborder sur les bords.

La pellicule de protection 9 présente les mêmes dimensions que la bande adhésive 8 et la plaque 2 et sur l'un des côtés est rapportée une languette 10 qui n'est pas collée à la face inférieure 2b de la plaque 2.

Cette languette 10 est terminée, à son extrémité libre, par un élément amovible 11 constituant un moyen de désactivation de la fonction enregistrement.

A cet effet, l'élément 11 est lié de façon amovible aux moyens d'enregistrement, par exemple au niveau du bouton de commande 4 de l'enregistrement.

Selon la forme particulière de réalisation représentée sur la figure 2, l'élément amovible 11 est constitué d'une sorte de punaise réalisant le contact au niveau du bouton 4. La présence de l'élément 11 autorise l'enregistrement tandis que son absence entraîne la suppression du contact et empêchant ainsi le fonctionnement des moyens d'enregistrement

Tout autre moyen connu de désactivation de la fonction enregistrement est cependant envisageable.

Le dispositif 1 fonctionne de la façon suivante :

Une fois le message enregistré par l'utilisateur, celui-ci retire la pellicule de protection 9 afin de découvrir la bande adhésive 8 pour fixer le dispositif 1 sur un objet ou support quelconque tel que des fleurs, un paquet à envoyer ou un cadeau, etc. En ôtant la pellicule de protection 9, l'utilisateur retire en même temps l'élément amovible 11, solidaire de la pellicule de protection 9 par l'intermédiaire de la languette 10.

Ainsi, en rendant active la bande adhésive 8 afin de fixer le dispositif 1 sur un support, l'utilisateur provoque en même temps la désactivation des moyens d'enregistrement, protégeant de ce fait son message.

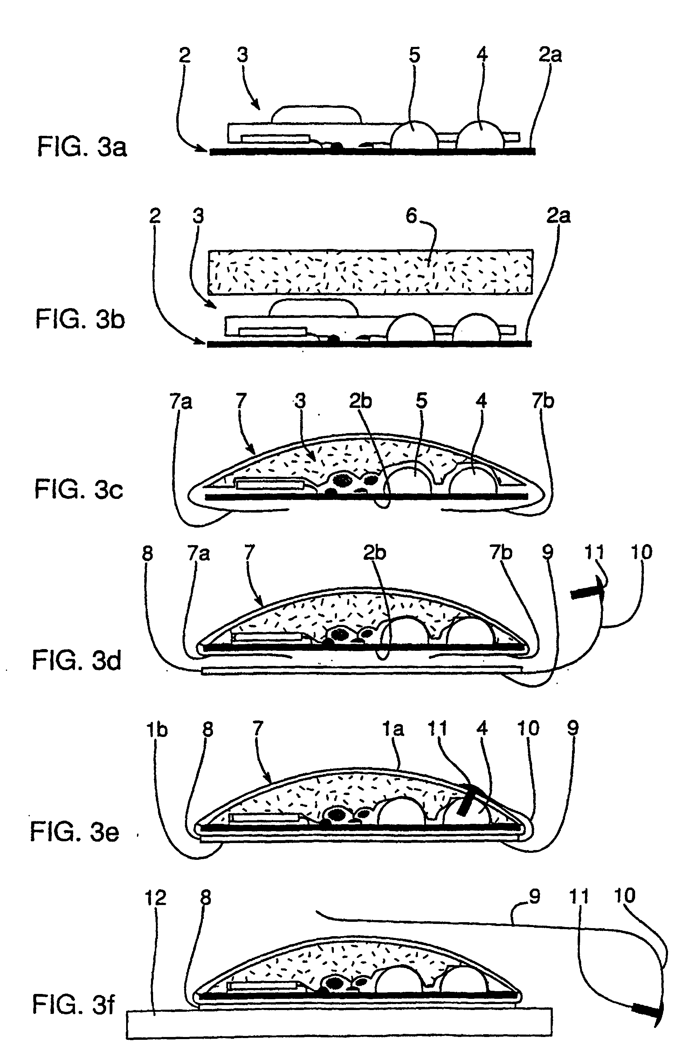

Les figures 3a à 3f décrivent, en coupe transversale, la séquence de montage des différents éléments composant le dispositif 1, jusqu'à sa fixation sur un support quelconque 12 (figure 3f).

Les figures 3a et 3b montrent la plaque de circuit imprimé 2 associée aux différents composants 3 incluant notamment les boutons de commande de l'enregistrement 4 et de la diffusion 5 des sons, tous ces éléments étant fixés sur la face supérieure 2a de la plaque 2.

La protection souple 6 vient se positionner sur l'ensemble des composants 3, au niveau de la face supérieure 2a de la plaque 2.

Afin de protéger le tout, une membrane de protection 7 est disposée par dessus les composants 3 (figure 3c) et est fixée sur la plaque 2 par l'intermédiaire des flancs d'extrémités 7a et 7b, constituant des rabats collés sur la face inférieure 2b de la plaque 2.

Cette membrane de protection peut avantageusement comporter différentes inscriptions, telles que l'identification des boutons de commande 4 et 5 ou tout autre texte ou information.

Les figures 3d et 3e montrent le positionnement des moyens de fixation du dispositif 1, comportant une bande adhésive 8 collée sur la face inférieure 2b de la plaque 2, par-dessus les flancs d'extrémités rabattus 7a et 7b de la membrane de protection 7.

La face de la bande adhésive 8 qui ne se trouve pas en contact avec la plaque 2 est recouverte d'une pellicule de protection 9 sur laquelle peuvent être imprimé toute sorte de texte, comme par exemple le mode d'emploi du dispositif 1.

Sur cette pellicule de protection 9 est rapportée une languette 10 reliant ladite pellicule 9 à l'élément amovible de désactivation 11 apte à être relié aux moyens d'enregistrement.

La figure 3e présente le dispositif 1 prêt à fonctionner.

L'élément amovible 11 est en contact avec le bouton de commande de l'enregistrement 4. La languette 10 relie cet élément amovible 11, disposé au niveau de la face supérieure 1a du dispositif, à la pellicule de protection 9 correspondant à la face inférieure 1b du dispositif.

L'utilisateur peut enregistrer son message, re-écouter celui-ci et recommencer plusieurs fois jusqu'à ce qu'il soit satisfait de l'enregistrement.

Une fois l'enregistrement définitif réalisé, il retire (figure 3f) la pellicule de protection 9 qui provoque, par l'intermédiaire de la languette 10, l'enlèvement de l'élément amovible de désactivation 11.

Les moyens d'enregistrement étant privés de contact avec le reste des composants 3, ils deviennent inactifs.

L'utilisateur peut alors fixer le dispositif 1 sur un support 12 par l'intermédiaire de la bande adhésive 8 mise à nue par le retrait de la pellicule de protection 9.

Ainsi, grâce au dispositif selon l'invention, il est possible d'accompagner n'importe quel objet d'un message sonore, et ce de façon très simple, tout en s'assurant que le message ne soit pas effacé accidentellement.

## Revendications

1. Dispositif enregistreur et diffuseur de sons (1) comportant des moyens d'enregistrement associés à des moyens de restitution desdits sons, des moyens de fixation (8) dudit dispositif sur un support (12), lesdits moyens de fixation (8) comprenant un moyen adhésif associé à un organe amovible de protection (9), ainsi que des moyens de désactivation (11) irréversible de la fonction enregistrement, **caractérisé en ce que** les moyens de désactivation (11) comprennent un élément amovible dont l'enlèvement provoque une rupture de contact, et solidaire de l'organe amovible de protection (9) des moyens de fixation (8).

2. Dispositif selon la revendication 1, **caractérisé en ce que** le moyen adhésif (8) est une bande adhésive double face et l'organe amovible de protection (9) est une pellicule détachable.

3. Dispositif selon l'une des revendications précédentes, **caractérisé en ce que** les moyens d'enregistrement et les moyens de restitution sont fixés sur une plaque de circuit imprimé (2).

4. Dispositif selon la revendication 3, **caractérisé en ce que** les moyens d'enregistrement et les moyens de restitution sont fixés sur une première face de la plaque de circuit imprimé (2).

5. Dispositif selon la revendication 4, **caractérisé en ce que** les moyens de fixation (8) sont fixés sur la seconde face de la plaque de circuit imprimé (2).

6. Dispositif selon l'une des revendications précédentes, **caractérisé en ce que** l'élément amovible (11) est relié à la pellicule de protection (9) par une languette (10).

7. Dispositif selon l'une des revendications précédentes, **caractérisé en ce que** les moyens d'enregistrement comprennent un microphone actionné par des moyens de commande tel qu'un bouton (4), et **en ce qu'**ils comprennent en outre une mémoire de type effaçable ré-enregistrable.

8. Dispositif selon l'une des revendications précédentes, **caractérisé en ce que** les moyens de restitution comprennent un haut-parleur actionné par des moyens de commande tel qu'un bouton (5).

## Patentansprüche

1. Vorrichtung zum Aufzeichnen und Wiedergeben von Tönen (1) mit Aufzeichnungsmitteln, die Mitteln zur Wiedergabe der Töne zugeordnet sind, Befestigungsmitteln (8) zum Befestigen der Vorrichtung auf einem Träger (12), wobei die Befestigungsmittel (8) ein Klebmittel umfassen, das einem entfernbaren Schutzelement (9) zugeordnet ist, sowie mit Mitteln (11) zum irreversiblen Deaktivieren der Aufzeichnungsfunktion, **dadurch gekennzeichnet, dass** die Mittel zum Deaktivieren (11) ein entfernbares Element umfassen, dessen Entfernung ein Brechen eines Kontakts verursacht, und das mit dem entfernbaren Schutzelement (9) der Befestigungsmittel (8) fest verbunden ist.

2. Vorrichtung nach Anspruch 1, **dadurch gekennzeichnet, dass** das Klebmittel (8) ein doppelseitiges Klebeband ist, und dass das entfernbare Schutzelement (9) ein ablösbarer Film ist.

3. Vorrichtung nach einem der vorhergehenden Ansprüche, **dadurch gekennzeichnet, dass** die Aufzeichnungsmittel und die Wiedergabemittel auf einer gedruckten Leiterplatte (2) befestigt sind.

4. Vorrichtung nach Anspruch 3, **dadurch gekennzeichnet, dass** die Aufzeichnungsmittel und die Wiedergabemittel auf einer ersten Seite der gedruckten Leiterplatte (2) befestigt sind.

5. Vorrichtung nach Anspruch 4, **dadurch gekennzeichnet, dass** die Befestigungsmittel (8) auf der zweiten Seite der gedruckten Leiterplatte (2) befestigt sind.

6. Vorrichtung nach einem der vorhergehenden Ansprüche, **dadurch gekennzeichnet, dass** das entfernbare Element (11) mit dem Schutzfilm (9) durch eine Lasche (10) verbunden ist.

7. Vorrichtung nach einem der vorhergehenden Ansprüche, **dadurch gekennzeichnet, dass** die Aufzeichnungsmittel ein durch ein Steuermittel wie etwa eine Taste (4) betätigtes Mikrofon umfassen, und dass sie außerdem einen Speicher vom löschbaren, überschreibbaren Typ umfassen.

8. Vorrichtung nach einem der vorhergehenden Ansprüche, **dadurch gekennzeichnet, dass** die Wiedergabemittel einen durch Steuermittel wie etwa eine Taste (5) betätigten Lautsprecher umfassen.

## Claims

1. Sound recording and reproduction device (1) comprising recording means associated with means for restituting said sounds, means (8) for fixation of said device on a support (12), said fixation means (8) comprising an adhesive means associated with a removable protection member (9), as well as means (11) for irreversibly de-activating the recording function, **characterized in that** the de-activation means (11) comprise a removable element which, when removed, causes a rupture of contact, and fast with the removable member (9) for protection of the fixation means (8).

2. Device according to Claim 1, **characterized in that** the adhesive means (8) is a double-faced adhesive tape and the removable protection member (9) is a detachable film.

3. Device according to one of the preceding Claims, **characterized in that** the recording means and the restituting means are fixed on a printed circuit board (2).

4. Device according to Claim 3, **characterized in that** the recording means and the restituting means are fixed on a first face of the printed circuit board (2).

5. Device according to Claim 4, **characterized in that** the fixation means (8) are fixed on the second face of the printed circuit board (2).

6. Device according to one of the preceding Claims, **characterized in that** the removable element (11) is connected to the protection film (9) by a tongue (10).

7. Device according to one of the preceding Claims, **characterized in that** the recording means comprise a microphone actuated by control means such as a button (4), and **in that** they further comprise a memory of erasable/rerecordable type.

8. Device according to one of the preceding Claims, **characterized in that** the restitution means comprise a loud-speaker actuated by control means such as a button (5).
